# EUROPEAN PATENT APPLICATION

(11) **EP 2 259 298 A1**
(43) Date of publication of application: **08.12.2010**
(21) Application number: 09719319.7
(22) Date of filing: 09.03.2009
(51) Int. Cl.: H01L 21/683, H01L 21/31, H02N 13/00

(54) **PLASMA TREATMENT APPARATUS, AND METHOD FOR CONTROLLING SUBSTRATE ATTRACTION FORCE IN PLASMA TREATMENT APPARATUS**

(30) Priority: 14.03.2008 JP 2008065049
(71) Applicant: Mitsubishi Heavy Industries, Ltd., Tokyo 108-8215 (JP)
(72) Inventor: MATSUDA, Ryuichi, Takasago-shi Hyogo 676-8686 (JP); MATSUKURA, Akihiko, Kobe-shi Hyogo 652-8585 (JP)
(74) Representative: Henkel, Feiler & Hänzel
(86) International application number: PCT/JP2009/054400
(87) International publication number: WO 2009/113481

(57) **Abstract**

An object is to provide a plasma processing apparatus and a method for controlling a substrate attraction force in a plasma processing apparatus by which the substrate attraction force is controlled to be constant without being influenced by the number of processed substrates. Therefore, change of a substrate potential is previously measured every constant integrated film thickness interval under a predetermined plasma processing condition (S1, S2), each reference attraction voltage at every constant integrated film thickness interval is obtained by adding a potential corresponding to a desired electrostatic attraction force to each of the measured substrate potentials, each set attraction voltage to be applied to a single electrode of an electrostatic chuck for each number of processed substrates is calculated on the basis of each of the obtained reference attraction voltages (S4), at the time of the plasma processing of the substrate under the predetermined plasma processing condition, each of the calculated set attraction voltages is applied to the single electrode for each number of processed substrates, so that the electrostatic attraction force on the substrate is made constant (S5).

## Description

### TECHNICAL FIELD

The present invention relates to a plasma processing apparatus which controls a substrate attraction force and also relates to a method for controlling a substrate attraction force in a plasma processing apparatus.

### BACKGROUND ART

In manufacturing a semiconductor device, a plasma processing apparatus such as a plasma CVD (Chemical Vapor Deposition) apparatus is used to form a film such as an insulating film. Recently, as required to be highly integrated and have higher-speed performance, the semiconductor device has been made finer. However, as the semiconductor device is made finer, more strict control on process conditions has been required also in forming a film such as an insulating film. For example, when an insulating film is formed in a plasma CVD apparatus, it is important to control the substrate temperature to within an appropriate range. In this respect, a substrate support table in the plasma CVD apparatus is provided with not only a temperature control device but also a substrate attracting device (a so-called electrostatic chuck). By using these devices, the temperature of the substrate support table is controlled to within an appropriate range and the substrate support table whose temperature is controlled to within the appropriate range attracts a substrate. This controls the substrate temperature to within an appropriate range.
Patent Document 1: Japanese Patent No. 3861030

### DISCLOSURE OF THE INVENTION

### PROBLEM TO BE SOLVED BY THE INVENTION

As described above, the substrate temperature is an important control factor in a manufacturing process of a semiconductor device or the like. When film forming is performed in the plasma CVD apparatus, the substrate is heated due to collision of charged particles in the plasma and cooled due to heat transmission between the substrate support table and the substrate. As a result, the substrate has a predetermined temperature, and thus a stable film forming characteristic (for example, a film formation rate or the like) is obtained. Nevertheless, actually, the stable film forming characteristic is not necessarily obtained. There is a problem that the film forming characteristic is changed in accordance with the number of substrates to be processed.

Although detailed description is given later, a possible cause of the change of the forming characteristic seems to be change of the substrate temperature due to change of an actual substrate attraction force in accordance with the number of processed substrates. In order to obtain a stable film forming characteristic, the substrate attraction force is required to be controlled to be constant without being influenced by the number of processed substrates.

The present invention has been made in view of the above problem. An object of the invention is to provide a plasma processing apparatus and a method for controlling a substrate attraction force in a plasma processing apparatus by which the substrate attraction force is controlled to be constant without being influenced by the number of processed substrates.

### MEANS FOR SOLVING THE PROBLEM

A plasma processing apparatus according to a first invention for solving the above problem comprises:
electrostatic attraction means for electrostatically attracting a substrate accommodated in a vacuum chamber onto a support table by applying an attraction voltage to a single electrode;
inductively-coupled plasma generation means for changing a gas in the vacuum chamber into plasma; and
control means for controlling the electrostatic attraction means and the plasma generation means,
the plasma processing apparatus performing plasma processing on the substrate attracted onto the support table, wherein
at the time of the plasma processing of the substrate, the control means increases the attraction voltage applied to the single electrode in accordance with the number of successively processed substrates or an integrated processing time.

A plasma processing apparatus according to a second invention for solving the above problem comprises:
electrostatic attraction means for electrostatically attracting a substrate accommodated in a vacuum chamber onto a support table by applying an attraction voltage to a single electrode;
inductively-coupled plasma generation means for changing a gas in the vacuum chamber into plasma; and
control means for controlling the electrostatic attraction means and the plasma generation means,
the plasma processing apparatus performing plasma processing on the substrate attracted onto the support table, wherein
in advance, the control means measures change of a substrate potential every constant integrated processing time interval under a predetermined plasma processing condition, obtains each reference attraction voltage at every constant integrated processing time interval by adding a potential corresponding to a desired electrostatic attraction force to each of the measured substrate potentials, and calculates each set attraction voltage to be applied to the single electrode for each number of processed substrates on the basis of each of the obtained reference attraction voltages, and
at the time of the plasma processing of the substrate under the predetermined plasma processing condition, the control means applies each of the calculated set attraction voltages to the single electrode for each number of processed substrates, so that the electrostatic attraction force on the substrate is made constant.

A plasma processing apparatus according to a third invention for solving the above problem comprises:
electrostatic attraction means for electrostatically attracting a substrate accommodated in a vacuum chamber onto a support table by applying an attraction voltage to a single electrode;
inductively-coupled plasma generation means for changing a gas in the vacuum chamber into plasma; and
control means for controlling the electrostatic attraction means and the plasma generation means,
the plasma processing apparatus performing plasma processing on the substrate attracted onto the support table, wherein
in advance, the control means measures change of a substrate potential every constant integrated processing time interval under a predetermined plasma processing condition, obtains each reference attraction voltage at every constant integrated processing time interval by adding a potential corresponding to a desired electrostatic attraction force to each of the measured substrate potentials, and calculates each set attraction voltage to be applied to the single electrode on the basis of each of the obtained reference attraction voltages in association with the integrated processing time, and
at the time of the plasma processing of the substrate under the predetermined plasma processing condition, the control means applies each of the calculated set attraction voltages to the single electrode in accordance with the integrated processing time, so that the electrostatic attraction force on the substrate is made constant.

A plasma processing apparatus according to a fourth invention for solving the above problem comprises:
electrostatic attraction means for electrostatically attracting a substrate accommodated in a vacuum chamber onto a support table by applying an attraction voltage to a single electrode;
bias application means for applying a self-bias potential to the substrate by supplying bias power to the single electrode while sharing the single electrode;
inductively-coupled plasma generation means for changing a gas in the vacuum chamber into plasma; and
control means for controlling the electrostatic attraction means, the bias application means and the plasma generation means,
the plasma processing apparatus performing plasma processing on the substrate attracted onto the support table, wherein
at the time of the plasma processing of the substrate, the control means keeps the bias power constant and increases the attraction voltage applied to the single electrode in accordance with the number of successively processed substrates or an integrated processing time.

A plasma processing apparatus according to a fifth invention for solving the above problem comprises:
electrostatic attraction means for electrostatically attracting a substrate accommodated in a vacuum chamber onto a support table by applying an attraction voltage to a single electrode;
bias application means for applying a self-bias potential to the substrate by supplying bias power to the single electrode while sharing the single electrode;
inductively-coupled plasma generation means for changing a gas in the vacuum chamber into plasma; and
control means for controlling the electrostatic attraction means, the bias application means and the plasma generation means,
the plasma processing apparatus performing plasma processing on the substrate attracted onto the support table, wherein
in advance, the control means measures change of a substrate potential every constant integrated processing time interval under a predetermined plasma processing condition while the bias power is constant, obtains each reference attraction voltage at every constant integrated processing time interval by adding a potential corresponding to a desired electrostatic attraction force to each of the measured substrate potentials, and calculates each set attraction voltage to be applied to the single electrode for each number of processed substrates on the basis of each of the obtained reference attraction voltages, and
at the time of the plasma processing of the substrate under the predetermined plasma processing condition, the control means applies each of the calculated set attraction voltages to the single electrode for each number of processed substrates, so that the electrostatic attraction force on the substrate is made constant.

A plasma processing apparatus according to a sixth invention for solving the above problem comprises:
electrostatic attraction means for electrostatically attracting a substrate accommodated in a vacuum chamber onto a support table by applying an attraction voltage to a single electrode;
bias application means for applying a self-bias potential to the substrate by supplying bias power to the single electrode while sharing the single electrode;
inductively-coupled plasma generation means for changing a gas in the vacuum chamber into plasma; and
control means for controlling the electrostatic attraction means, the bias application means and the plasma generation means,
the plasma processing apparatus performing plasma processing on the substrate attracted onto the support table, wherein
in advance, the control means measures change of a substrate potential every constant integrated processing time interval under a predetermined plasma processing condition while the bias power is constant, obtains each reference attraction voltage at every constant integrated processing time interval by adding a potential corresponding to a desired electrostatic attraction force to each of the measured substrate potentials, and calculates each set attraction voltage to be applied to the single electrode on the basis of each of the obtained reference attraction voltages in association with the integrated processing time, and
at the time of the plasma processing of the substrate under the predetermined plasma processing condition, the control means applies each of the calculated set attraction voltages to the single electrode in accordance with the integrated processing time, so that the electrostatic attraction force on the substrate is made constant.

A plasma processing apparatus according to a seventh invention for solving the above problem comprises:
electrostatic attraction means for electrostatically attracting a substrate accommodated in a vacuum chamber onto a support table by applying an attraction voltage to a single electrode;
bias application means for applying a self-bias potential to the substrate by supplying bias power to the single electrode while sharing the single electrode;
inductively-coupled plasma generation means for changing a gas in the vacuum chamber into plasma; and
control means for controlling the electrostatic attraction means, the bias application means and the plasma generation means,
the plasma processing apparatus performing plasma processing on the substrate attracted onto the support table, wherein
at the time of the plasma processing of the substrate, the control means keeps the attraction voltage constant and increases the bias power to be supplied to the single electrode in accordance with the number of successively processed substrates or an integrated processing time.

A plasma processing apparatus according to an eighth invention for solving the above problem comprises:
electrostatic attraction means for electrostatically attracting a substrate accommodated in a vacuum chamber onto a support table by applying an attraction voltage to a single electrode;
bias application means for applying a self-bias potential to the substrate by supplying bias power to the single electrode while sharing the single electrode;
inductively-coupled plasma generation means for changing a gas in the vacuum chamber into plasma; and
control means for controlling the electrostatic attraction means, the bias application means and the plasma generation means,
the plasma processing apparatus performing plasma processing on the substrate attracted onto the support table, wherein
in advance, the control means measures change of a substrate potential every constant integrated processing time interval under a predetermined plasma processing condition while the bias power is set at zero, obtains each reference bias power at every constant integrated processing time interval by obtaining each bias power corresponding to the self-bias potential offsetting each change of the measured substrate potentials, and calculates each set bias power to be supplied to the single electrode for each number of processed substrates on the basis of each of the obtained reference bias powers, and
at the time of the plasma processing of the substrate under the predetermined plasma processing condition, the control means keeps the attraction voltage constant and supplies each of the calculated set bias powers to the single electrode for each number of processed substrates, so that an electrostatic attraction force on the substrate is made constant.

A plasma processing apparatus according to a ninth invention for solving the above problem comprises:
electrostatic attraction means for electrostatically attracting a substrate accommodated in a vacuum chamber onto a support table by applying an attraction voltage to a single electrode;
bias application means for applying a self-bias potential to the substrate by supplying bias power to the single electrode while sharing the single electrode;
inductively-coupled plasma generation means for changing a gas in the vacuum chamber into plasma; and
control means for controlling the electrostatic attraction means, the bias application means and the plasma generation means,
the plasma processing apparatus performing plasma processing on the substrate attracted onto the support table, wherein
in advance, the control means measures change of a substrate potential every constant integrated processing time interval under a predetermined plasma processing condition while the bias power is set at zero, obtains each reference bias power at every constant integrated processing time interval by obtaining each bias power corresponding to the self-bias potential offsetting each change of the measured substrate potentials, and calculates each set bias power to be supplied to the single electrode on the basis of each of the obtained reference bias powers in association with the integrated processing time, and
at the time of the plasma processing of the substrate under the predetermined plasma processing condition, the control means keeps the attraction voltage constant and supplies each of the calculated set bias powers to the single electrode in accordance with the integrated processing time, so that an electrostatic attraction force on the substrate is made constant.

A method for controlling a substrate attraction force in a plasma processing apparatus according to a tenth invention for solving the above problem is a method for controlling a substrate attraction force in a plasma processing apparatus which electrostatically attracts a substrate accommodated in a vacuum chamber onto a support table by applying an attraction voltage to a single electrode of electrostatic attraction means, changes a gas in the vacuum chamber into plasma by inductively-coupled plasma generation means, and performs plasma processing on the substrate attracted onto the support table,
the method comprising, at the time of the plasma processing of the substrate, increasing the attraction voltage applied to the single electrode in accordance with the number of successively processed substrates or an integrated processing time.

A method for controlling a substrate attraction force in a plasma processing apparatus according to an eleventh invention for solving the above problem is a method for controlling a substrate attraction force in a plasma processing apparatus which electrostatically attracts a substrate accommodated in a vacuum chamber onto a support table by applying an attraction voltage to a single electrode of electrostatic attraction means, changes a gas in the vacuum chamber into plasma by inductively-coupled plasma generation means, and performs plasma processing on the substrate attracted onto the support table,
the method comprising:
in advance, measuring change of a substrate potential every constant integrated processing time interval under a predetermined plasma processing condition, obtaining each reference attraction voltage at every constant integrated processing time interval by adding a potential corresponding to a desired electrostatic attraction force to each of the measured substrate potentials, and calculating each set attraction voltage to be applied to the single electrode for each number of processed substrates on the basis of each of the obtained reference attraction voltages; and
at the time of the plasma processing of the substrate under the predetermined plasma processing condition, applying each of the calculated set attraction voltages to the single electrode for each number of processed substrates, so that the electrostatic attraction force on the substrate is made constant.

A method for controlling a substrate attraction force in a plasma processing apparatus according to a twelfth invention for solving the above problem is a method for controlling a substrate attraction force in a plasma processing apparatus which electrostatically attracts a substrate accommodated in a vacuum chamber onto a support table by applying an attraction voltage to a single electrode of electrostatic attraction means, changes a gas in the vacuum chamber into plasma by inductively-coupled plasma generation means, and performs plasma processing on the substrate attracted onto the support table,
the method comprising:
in advance, measuring change of a substrate potential every constant integrated processing time interval under a predetermined plasma processing condition, obtaining each reference attraction voltage at every constant integrated processing time interval by adding a potential corresponding to a desired electrostatic attraction force to each of the measured substrate potentials, and calculating each set attraction voltage to be applied to the single electrode on the basis of each of the obtained reference attraction voltages in association with the integrated processing time; and
at the time of the plasma processing of the substrate under the predetermined plasma processing condition, applying each of the calculated set attraction voltages to the single electrode in accordance with the integrated processing time, so that the electrostatic attraction force on the substrate is made constant.

A method for controlling a substrate attraction force in a plasma processing apparatus according to a thirteenth invention for solving the above problem is a method for controlling a substrate attraction force in a plasma processing apparatus which electrostatically attracts a substrate accommodated in a vacuum chamber onto a support table by applying an attraction voltage to a single electrode of electrostatic attraction means, applies a self-bias potential to the substrate by supplying bias power to the single electrode by bias application means sharing the single electrode, changes a gas in the vacuum chamber into plasma by inductively-coupled plasma generation means, and performs plasma processing on the substrate attracted onto the support table,
the method comprising, at the time of the plasma processing of the substrate, keeping the bias power constant and increasing the attraction voltage applied to the single electrode in accordance with the number of successively processed substrates or an integrated processing time.

A method for controlling a substrate attraction force in a plasma processing apparatus according to a fourteenth invention for solving the above problem is a method for controlling a substrate attraction force in a plasma processing apparatus which electrostatically attracts a substrate accommodated in a vacuum chamber onto a support table by applying an attraction voltage to a single electrode of electrostatic attraction means, applies a self-bias potential to the substrate by supplying bias power to the single electrode by bias application means sharing the single electrode, changes a gas in the vacuum chamber into plasma by inductively-coupled plasma generation means, and performs plasma processing on the substrate attracted onto the support table, the method comprising:
in advance, measuring change of a substrate potential every constant integrated processing time interval under a predetermined plasma processing condition while the bias power is constant, obtaining each reference attraction voltage at every constant integrated processing time interval by adding a potential corresponding to a desired electrostatic attraction force to each of the measured substrate potentials, and calculating each set attraction voltage to be applied to the single electrode for each number of processed substrates on the basis of each of the obtained reference attraction voltages; and
at the time of the plasma processing of the substrate under the predetermined plasma processing condition, applying each of the calculated set attraction voltages to the single electrode for each number of processed substrates, so that the electrostatic attraction force on the substrate is made constant.

A method for controlling a substrate attraction force in a plasma processing apparatus according to a fifteenth invention for solving the above problem is a method for controlling a substrate attraction force in a plasma processing apparatus which electrostatically attracts a substrate accommodated in a vacuum chamber onto a support table by applying an attraction voltage to a single electrode of electrostatic attraction means, applies a self-bias potential to the substrate by supplying bias power to the single electrode by bias application means sharing the single electrode, changes a gas in the vacuum chamber into plasma by inductively-coupled plasma generation means, and performs plasma processing on the substrate attracted onto the support table,
the method comprising:
in advance, measuring change of a substrate potential every constant integrated processing time interval under a predetermined plasma processing condition while the bias power is constant, obtaining each reference attraction voltage at every constant integrated processing time interval by adding a potential corresponding to a desired electrostatic attraction force to each of the measured substrate potentials, and calculating each set attraction voltage to be applied to the single electrode on the basis of each of the obtained reference attraction voltages in association with the integrated processing time; and
at the time of the plasma processing of the substrate under the predetermined plasma processing condition, applying each of the calculated set attraction voltages to the single electrode in accordance with the integrated processing time, so that the electrostatic attraction force on the substrate is made constant.

A method for controlling a substrate attraction force in a plasma processing apparatus according to a sixteenth invention for solving the above problem is a method for controlling a substrate attraction force in a plasma processing apparatus which electrostatically attracts a substrate accommodated in a vacuum chamber onto a support table by applying an attraction voltage to a single electrode of electrostatic attraction means, applies a self-bias potential to the substrate by supplying bias power to the single electrode by bias application means sharing the single electrode, changes a gas in the vacuum chamber into plasma by inductively-coupled plasma generation means, and performs plasma processing on the substrate attracted onto the support table,
the method comprising, at the time of the plasma processing of the substrate, keeping the attraction voltage constant and increasing the bias power to be supplied to the single electrode in accordance with the number of successively processed substrates or an integrated processing time.

A method for controlling a substrate attraction force in a plasma processing apparatus according to a seventeenth invention for solving the above problem is a method for controlling a substrate attraction force in a plasma processing apparatus which electrostatically attracts a substrate accommodated in a vacuum chamber onto a support table by applying an attraction voltage to a single electrode of electrostatic attraction means, applies a self-bias potential to the substrate by supplying bias power to the single electrode by bias application means sharing the single electrode, changes a gas in the vacuum chamber into plasma by inductively-coupled plasma generation means, and performs plasma processing on the substrate attracted onto the support table,
the method comprising:
in advance, measuring change of a substrate potential every constant integrated processing time interval under a predetermined plasma processing condition while the bias power is set at zero, obtaining each reference bias power at every constant integrated processing time interval by obtaining each bias power corresponding to the self-bias potential offsetting each change of the measured substrate potentials, and calculating each set bias power to be supplied to the single electrode for each number of processed substrates on the basis of each of the obtained reference bias powers; and
at the time of the plasma processing of the substrate under the predetermined plasma processing condition, keeping the attraction voltage constant and supplying each of the calculated set bias powers to the single electrode for each number of processed substrates, so that an electrostatic attraction force on the substrate is made constant.

A method for controlling a substrate attraction force in a plasma processing apparatus according to an eighteenth invention for solving the above problem is a method for controlling a substrate attraction force in a plasma processing apparatus which electrostatically attracts a substrate accommodated in a vacuum chamber onto a support table by applying an attraction voltage to a single electrode of electrostatic attraction means, applies a self-bias potential to the substrate by supplying bias power to the single electrode by bias application means sharing the single electrode, changes a gas in the vacuum chamber into plasma by inductively-coupled plasma generation means, and performs plasma processing on the substrate attracted onto the support table,
the method comprising:
in advance, measuring change of a substrate potential every constant integrated processing time interval under a predetermined plasma processing condition while the bias power is set at zero, obtaining each reference bias power at every constant integrated processing time interval by obtaining each bias power corresponding to the self-bias potential offsetting each change of the measured substrate potentials, and calculating each set bias power to be supplied to the single electrode on the basis of each of the obtained reference bias powers in association with the integrated processing time; and
at the time of the plasma processing of the substrate under the predetermined plasma processing condition, keeping the attraction voltage constant and supplying each of the calculated set bias powers to the single electrode in accordance with the integrated processing time, so that an electrostatic attraction force on the substrate is made constant.

### EFFECTS OF THE INVENTION

According to the first, second, fourth, fifth, seventh, eighth, tenth, eleventh, thirteenth, fourteenth, sixteenth and seventeenth inventions, the attraction voltage or the bias power to be applied to the single electrode is controlled based on the number of processed substrates. Thus, the substrate attraction force can be controlled to be constant independent of the number of processed substrates. Consequently, the temperatures of the substrates at the time of the plasma processing can be kept constant. Accordingly, process can be stabilized. In addition, this leads to reduction in cleaning frequency and improvement of CoO.

According to the first, third, fourth, sixth, seventh, ninth, tenth, twelfth, thirteenth, fifteenth, sixteenth and eighteenth inventions, the attraction voltage or the bias power to be applied to the single electrode is controlled based on the integrated time interval. Thus, the substrate attraction force can be controlled to be constant independent of the integrated time interval. Consequently, the temperatures of the substrates at the time of the plasma processing can be kept constant, and the substrate temperature of a single substrate at the time of processing can be kept constant as well. This can reduce change in characteristic due to the plasma processing. Accordingly, process can be stabilized further. In addition, this leads to reduction in cleaning frequency and improvement of CoO.

### BRIEF DESCRIPTION OF THE DRAWINGS

[Fig. 1] Fig. 1 is a schematic configuration diagram showing an example of an embodiment of a plasma processing apparatus according to the present invention.
[Fig. 2] Fig. 2 is a flowchart showing a method for controlling a substrate attraction force according to Embodiment 1.
[Fig. 3] Fig. 3 is a time chart explaining the method for controlling a substrate attraction force according to Embodiment 1.
[Fig. 4] Fig. 4 is a flowchart showing a method for controlling a substrate attraction force according to Embodiment 2.
[Fig. 5] Fig. 5 is a time chart explaining the method for controlling a substrate attraction force according to Embodiment 2.
[Fig. 6] Fig. 6 is a flowchart showing a method for controlling a substrate attraction force according to Embodiment 3.
[Fig. 7] Fig. 7 is a time chart explaining the method for controlling a substrate attraction force according to Embodiment 3.
[Fig. 8] Fig. 8 is a flowchart showing a method for controlling a substrate attraction force according to Embodiment 4.
[Fig. 9] Fig. 9 is a time chart explaining the method for controlling a substrate attraction force according to Embodiment 4.
[Fig. 10] Fig. 10 is a schematic configuration diagram of a general plasma CVD apparatus.
[Fig. 11] Part (a) of Fig. 11 is a graph showing a film thickness on a wall surface and a plasma potential (substrate potential). Part (b) of Fig. 11 is a graph showing bias power and a self-bias potential. Part (c) of Fig. 11 is a graph showing a potential difference and an attraction force.
[Fig. 12] Fig. 12 illustrates potentials in regions. Part (a) of Fig. 12 shows a case where a bias is applied. Part (b) of Fig. 12 shows a case where a bias is not applied.

### EXPLANATION OF REFERENCE NUMERALS

- 2: vacuum chamber
- 3: film forming chamber
- 4: ceiling plate
- 5: substrate support table
- 6: substrate
- 7: substrate placement portion
- 11: bias power supply
- 13: electrostatic chuck power supply
- 14: temperature controller
- 16: fed antenna
- 20: electrostatic chuck electrode
- 26: controller
- 27: temperature detector

### BEST MODES FOR CARRYING OUT THE INVENTION

As described above, the conventional plasma processing apparatus has a problem that the film forming characteristic is changed in accordance with the number of processed substrates. Earnestly reviewing this problem, the inventor and others have found the following cause.

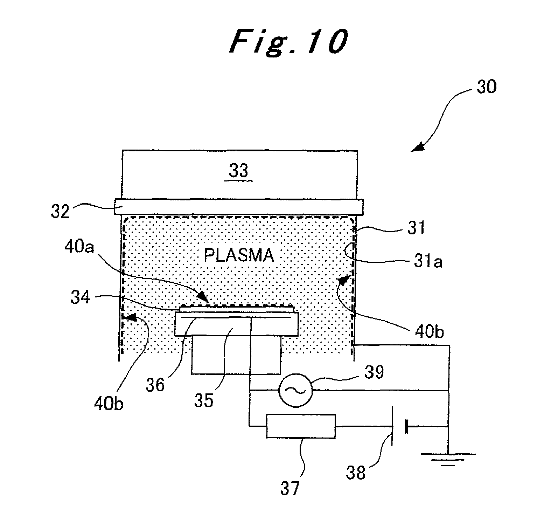

Firstly, a schematic configuration diagram of a general plasma CVD apparatus as a model is shown Fig. 10. When being outlined, the plasma CVD apparatus is a one using a single electrode as an electrode for an electrostatic chuck and including a biasing device by which a bias is applied to a substrate and an inductively-coupled plasma generating mechanism.

Specifically, a plasma CVD apparatus 30 includes: a vacuum chamber 31 which is made of a metal material; and a ceiling plate 32 which is made of an insulating material and closes a top of the vacuum chamber 31. The inside defined by the vacuum chamber 31 and the ceiling plate 32 is a film forming chamber. A plasma source 33 (an inductively-coupled plasma generating mechanism formed by, for example, an antenna, a thigh-frequency matching circuit, a high-frequency power supply and the like) is provided on top of the ceiling plate 32. An electromagnetic wave emitted from the plasma source 33 goes through the ceiling plate 32 and then enters the film forming chamber. Injected plasma changes gases supplied into the film forming chamber into a plasma state. This makes it possible to form a film such as an insulating film. In addition, an electrostatic chuck 35 which is a support table for supporting a substrate 34 is provided inside the film forming chamber. For electrostatic attraction, the electrostatic chuck 35 has its surface made of an insulating material, and is provided, in its inside, with an electrostatic chuck electrode 36 which is a single electrode. An electrostatic chuck power supply 38 which applies a direct-current voltage for attracting the substrate 34 is connected to the electrostatic chuck electrode 36 via a low pass filter (LPF) 37. In addition, a bias power supply 39 and an unillustrated matching circuit are connected to the electrostatic chuck electrode 36, the bias power supply 39 applying a bias to the substrate 34 by supplying high-frequency bias power. In sum, the electrostatic chuck electrode 36 functions as an electrostatic attracting device but also as a biasing element.

Normally, when film forming is performed in the plasma CVD apparatus 30 having the above configuration, an insulating film 40a is formed on a surface of the substrate 34 and an insulating film 40b is also formed on a wall surface 31a which is a wall surface of the vacuum chamber 31. Accordingly, a film thickness of the insulating film 40b formed and deposited on the wall surface 31a is increased in accordance with the number of processed substrates 34. This means change of an electrical state on the wall surface 31a side, and consequently leads to change of a plasma potential.

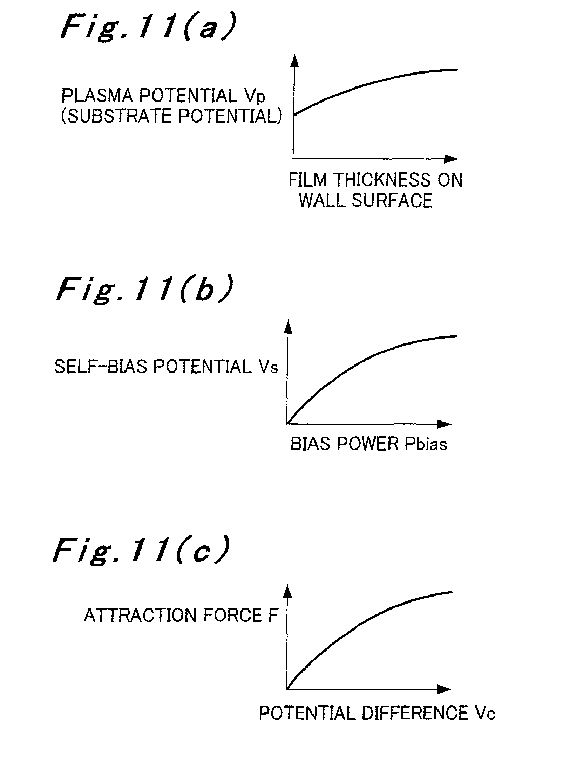

The change of the plasma potential will be described in detail by referring to Figs. 10 to 12.
The vacuum chamber 31 made of a metal material is grounded as shown in Fig. 10, and the potential thereof is 0 volts. As described above, in accordance with the number of processed substrates 34, the insulating film 40b deposits on the wall surface 31a and the film thickness thereof is increased. Being involved with this, an impedance, of the insulating film 40b, seen from the plasma side is changed, and consequently a plasma potential Vp is increased as shown in Part (a) of Fig. 11. Since the substrate 34 is in the plasma at this time, the substrate 34 placed on the electrostatic chuck 35 having the surface formed of an insulating body is electrically insulated from the vacuum chamber 31. Accordingly, when no bias is applied, the substrate 34 has a potential approximately equal to the plasma potential Vp.

In contrast, when a bias is applied to the substrate 34 from the bias power supply 39, a self-bias potential Vs is applied to the substrate 34. As a result, a substrate potential Vw becomes a potential of the plasma potential Vp minus the self-bias potential Vs. This means Vw≈Vp at the time of no bias application, while Vw≈Vp-Vs at the time of bias application. Note that the self-bias potential Vs tends to increase as bias power Pbias increases, as shown in Part (b) of Fig. 11.

Meanwhile, a set potential V for the electrostatic chuck is applied to the electrostatic chuck electrode 36 according to setting of the electrostatic chuck power supply 38. An attraction force F acting on the substrate 34 is related to a difference between the set potential V at the electrostatic chuck electrode 36 and the substrate potential Vw at the substrate 34, i.e., a potential difference Vc = V - Vw. Thus, the potential difference Vc is expressed as Vc≈V-Vp for a case of no bias application, while the potential difference Vc is expressed as Vc≈V-(Vp-Vs) for a case of bias application.

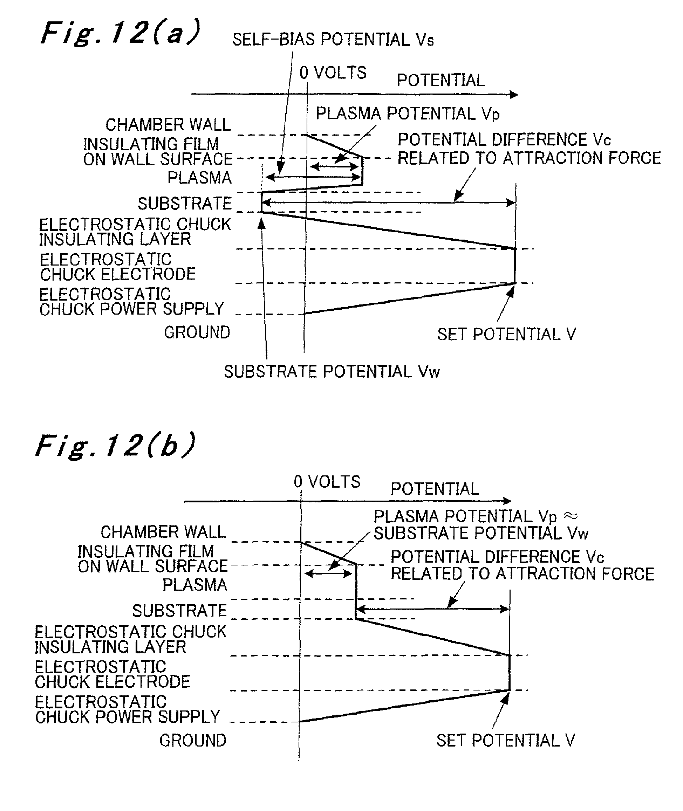

When being illustrated based on what is described above, potentials in regions of the chamber wall, the insulating film of the wall surface, plasma, the substrate, the insulating layer on the electrostatic chuck, the electrostatic chuck electrode, the electrostatic chuck power supply and the ground, respectively, have relationships shown in Parts (a) and (b) of Fig. 12. Note that Part (a) of Fig. 12 shows a case of bias application, while Part (b) of Fig. 12 shows a case of no bias application.

Normally, heat transmission between the electrostatic chuck 35 and the substrate 34 can be adjusted to some extent by controlling the attraction force F of the electrostatic chuck. When the electrostatic chuck electrode 36 is a single electrode, the attraction force F is determined by the aforementioned potential difference Vc, as shown in Part (c) of Fig. 11.

Accordingly, in order to keep the substrate temperature constant, it is necessary to keep the potential difference Vc constant and thus to keep the attraction force F constant. However, as described above, the plasma potential Vp fluctuates in accordance with the number of processed substrates 34. Thus, it is not easy to keep the potential difference Vc and thus to keep the attraction force F constant, that is, to keep the substrate temperature constant. For this reason, the plasma potential and the substrate attraction force are changed in accordance with the number of processed substrates, and consequently the substrate temperature is not kept constant. It is found that this causes a problem that the forming characteristic is changed.

Note that there is a method for keeping the substrate temperature constant by performing dry cleaning of the wall surface 31a and a conditioning process for each substrate and thereby resetting the state of the wall surface 31a for each substrate. The method, however, leads to reduction in throughput and increase in cleaning gas consumption, and causes deterioration of CoO (Cost of Ownership) which is an index of the performance of an apparatus.

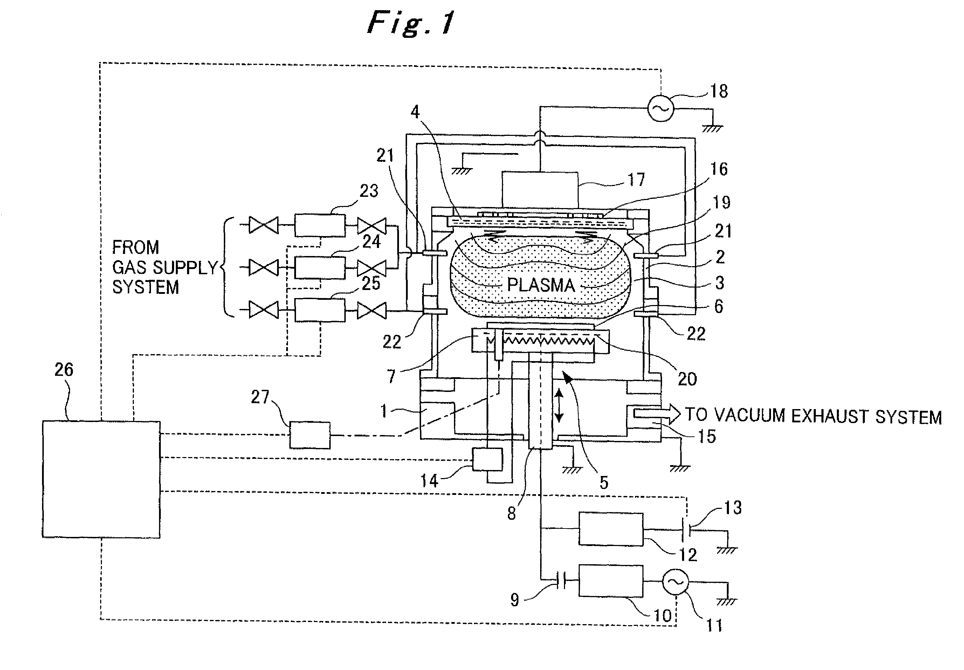

Based on the aforementioned finding, the inventor and others come to realize that, by using a control apparatus and a control method shown below, the substrate attraction force is controlled to be constant independent of the number of processed substrates and further independent of an integrated processing time. Hence, embodiments of a plasma processing apparatus and a method for controlling a substrate attraction force in the plasma processing apparatus according to the present invention are described by referring to Figs. 1 to 9.

Note that since descriptions are given based on a plasma CVD apparatus in the embodiments below, the descriptions are given by reading the "integrated processing time" as an "integrated film thickness" for easy understanding in the descriptions below. Incidentally, in the plasma CVD apparatus, [(integrated film thickness) = (integrated processing time) × (film formation rate)], and the "integrated film thickness" has a proportional relationship with the "integrated processing time."

### EMBODIMENT 1

Fig. 1 is a schematic configuration diagram showing an example of an embodiment of a plasma processing apparatus according to the present invention. A method for controlling a substrate attraction force according to the present invention is performed in the plasma processing apparatus.

As shown in Fig. 1, a plasma CVD apparatus which is the plasma processing apparatus according to the present invention is provided, on a base 1 thereof, with a cylindrical vacuum chamber 2 made of a metal such as aluminum. The inside of the vacuum chamber 2 is a film forming chamber 3. A circular ceiling plate 4 made of an insulating material is provided on top of the film forming chamber 3. A substrate support table 5 is provided in the film forming chamber 3. The substrate support table 5 includes a disc-shaped substrate placement portion 7 for placing a substrate 6 on which a semiconductor device is formed. The substrate placement portion 7 is supported by a support shaft 8. The substrate placement portion 7 is made of a ceramic material such as Al₂O₃ or AlN, and serves as an electrostatic chuck which electrostatically attracts and holds the substrate 6 placed on the substrate placement portion 7 when direct current power is supplied from an electrostatic chuck power supply 13 to be described later.

The substrate 6 is a disc-shaped Si wafer. As are well known, there are wafers having various wafer sizes such as a wafer of ϕ200 mm (8 inches) and a wafer of ϕ300 mm (12 inches). An electrostatic chuck electrode 20, which is a single electrode, is provided in the substrate placement portion 7. The electrostatic chuck power supply 13 for the electrostatic chuck is connected to the electrostatic chuck electrode 20 via a low pass filter (LPF) 12 to supply direct-current power for the electrostatic chuck (electrostatic attraction means). In addition, a bias power supply 11 is also connected to the electrostatic chuck electrode 20 via a matching circuit 10 for performing impedance matching and a capacitor 9. The electrostatic chuck electrode 20 serves as a biasing electrode (bias application means).

Accordingly, high-frequency power is supplied from the bias power supply 11 and thereby a high-frequency (several hundreds of kHz or more) bias is applied to the substrate placement portion 7 and the substrate 6. Bias power at this time is adjusted as appropriate by the bias power supply 11. In addition, direct-current power is supplied from the electrostatic chuck power supply 13. An electrostatic force thereby generated on the substrate placement portion 7 causes the substrate 6 to be attracted onto the substrate placement portion 7. Note that the substrate support table 5 is designed to be freely moved up and down as a whole or the support shaft 8 is designed to be freely extendable and retractable, and thereby the height of the substrate 6 in the up and down direction can be adjusted to an optimum height.

Meanwhile, a temperature controller 14 is provided to the substrate placement portion 7. The temperature controller 14 is designed to control the temperature of the substrate placement portion 7. Note that, as the temperature controller 14, a heater may be provided in the substrate placement portion 7, and by using the heater, the temperature of the substrate placement portion 7 is controlled to a desired temperature, for example. Alternatively, a flow path may be provided in the substrate placement portion 7, and by controlling the temperature of a fluid passing through the flow path, the temperature of the substrate placement portion 7 is controlled to a desired temperature.

The base 1 is provided with an exhaust port 15. A gas in the film forming chamber 3 is exhausted to an unillustrated vacuum exhaust system via the exhaust port 15, and this results in a low-pressure state (vacuum state) in the film forming chamber 3. Thus, various gasses for film forming are supplied into the film forming chamber 3 in the low-pressure state. In addition, ports (illustration omitted) for supplying and withdrawing the substrate 6 are provided to the vacuum chamber 2 to supply and withdraw the substrate 6 from and to unillustrated conveyance chambers.

A spiral fed antenna 16 is provided on the ceiling plate 4. A high-frequency power supply 18 is connected to the fed antenna 16 via a matching circuit 17 for performing impedance matching. Accordingly, high-frequency power is supplied from the high-frequency power supply 18 to the fed antenna 16, and thereby an electromagnetic wave 19 goes through the ceiling plate 4 serving as an electromagnetic transmission window from the fed antenna 16 and enters the film forming chamber 3. Energy (high-frequency power) of the electromagnetic wave 19 changes various gasses supplied into the film forming chamber 3 into a plasma state (plasma generating means). This configuration is a configuration of a so-called inductively-coupled plasma generating mechanism.

The vacuum chamber 2 is provided with nozzles 21, 22 for introducing the various gasses fed from an unillustrated gas supply system into the film forming chamber 3- For example, when a silicon nitride film (SiₓN_{y} film) is formed in the plasma CVD apparatus shown in Fig. 1, N₂, NH₃ or the like is supplied as a nitride gas from the nozzle 21, while SiH₄ is supplied as a raw material gas from the nozzle 22. The supply amounts of these gasses are adjusted by an MFC (Mass Flow Controller) 23 and an MFC 25. Alternatively, from the nozzle 21, an Ar gas or the like whose flow rate is adjusted by an MFC 24 may be supplied.

These gasses are introduced into the film forming chamber 3, and are changed into the plasma state by using the high-frequency power from the high-frequency power supply 18, so that a chemical reaction on a surface of the substrate 6 is accelerated by using active particles (exciting atoms or molecules) in the plasma. Thereby, a SiₓN_{y} film, which is a silicon nitride film, is formed on the substrate 6. The SiₓN_{y} film is used as an insulating film for insulation between elements, wirings or the like, as a protective film for protecting elements, or the like.

Besides, a temperature detector 27 is provided to the plasma CVD apparatus according to the present invention, for measuring a substrate potential to be described later. The temperature detector 27 may be constituted of an optical fiber, an infrared thermometer, and the like, for example. The optical fiber penetrates the substrate placement portion 7, and a tip end of the optical fiber faces a back surface of the substrate 6 without coming in contact with the back surface. The infrared thermometer obtains an optical signal (for example, an infrared ray) from the back surface of the substrate 6 through the optical fiber, and detects the optical signal as the temperature of the substrate 6.

A controller 26 having a microcomputer controls the MFCs 23, 24, 25 in accordance with a predetermined control sequence, and thereby controls supply timings and the supply amounts of the various gasses. In addition, the controller 26 controls the high-frequency power supply 18, the bias power supply 11, the temperature controller 14 and the electrostatic chuck power supply 13, and also controls supply timings and supply powers of these power supplies. Furthermore, the controller 26 measures the substrate potential to be described later by using the temperature detector 27.

Involved with film forming processing performed on the substrate 6 as described above in the above plasma CVD apparatus, an insulating film formed by the film forming deposits also on an inner wall of the vacuum chamber 2, and thus an impedance on the vacuum chamber 2 side is changed. With this change, a plasma potential, the substrate potential and a potential difference related to an attraction force of the substrate 6 are changed, and consequently the temperature of the substrate 6 is changed. This leads to process instability.

Hence, in this embodiment, by performing a method for controlling a substrate attraction force to be described below, the substrate attraction force is controlled to be constant independent of the number of processed substrates. As a result, the substrate temperature is kept constant, so that process stability is obtained.

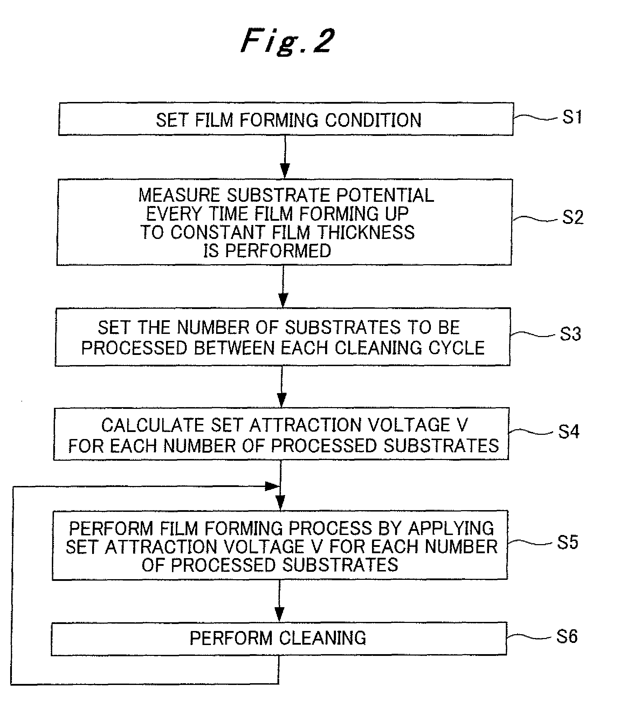

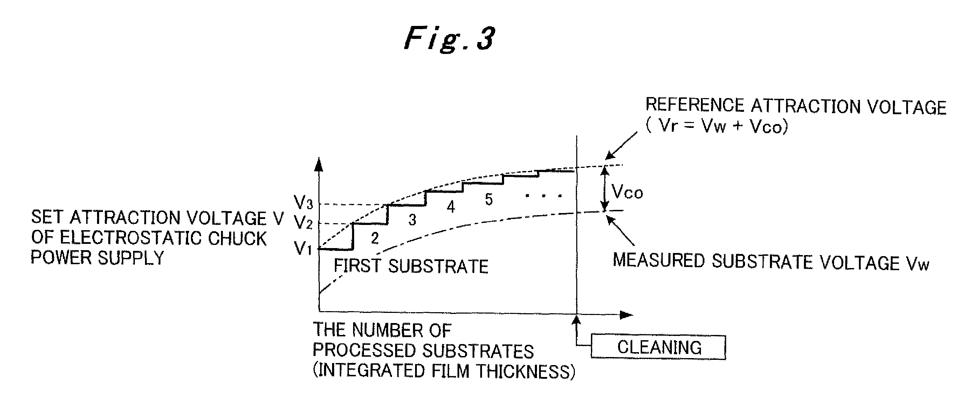

Hereinbelow, the method for controlling a substrate attraction force according to this embodiment is described by referring to Fig. 2 and Fig. 3. Note that Fig. 2 is a flowchart showing the method for controlling a substrate attraction force according to this embodiment and Fig. 3 is a time chart explaining the method for controlling a substrate attraction force according to this embodiment.

The method for controlling a substrate attraction force according to this embodiment is performed by the controller 26 shown in Fig. 1 in steps shown in Fig. 2.

A film forming condition to be used in an actual manufacturing process is set (Step S1). Note that this embodiment assumes a film forming condition that the bias power is zero or constant. Then, after conditioning (initialization by plasma cleaning) of the vacuum chamber 2, film forming is performed on the substrate 6 at constant film thickness intervals based on this film forming condition. Every time film forming up to the constant film thickness is performed, a substrate potential is measured by the method to be described later (Step S2). As a result of the measurement, change of a substrate potential Vw with respect to an integrated film thickness can be obtained at every constant integrated film thickness intervals (see a chain line in a graph in Fig. 3). In other words, a relationship between the integrated film thickness and the substrate potential Vw is in advance obtained by using the film forming condition of the actual manufacturing process.

In the present invention, cleaning is not required for each substrate. However, in the actual manufacturing process, if cleaning is performed every time multiple substrates are processed, the process stability is improved further. Thus, the number of substrates to be processed between each cleaning cycle is set (Step S3).

A set attraction voltage V to be set for each number of processed substrates is calculated (Step S4, see a solid line in the graph in Fig. 3).
Specifically, a reference attraction voltage Vr serving as a reference in setting for the electrostatic chuck power supply 13 is first obtained based on the relationship of the substrate potential Vw with the integrated film thickness, which is obtained in Step S2 above. In the plasma CVD apparatus shown in Fig. 1, if a voltage difference Vc which is a difference between a set attraction voltage V to be set for the electrostatic chuck power supply 13 and the substrate potential Vw is always constant, an attraction force F is constant. Thus, when a constant potential difference Vc₀ is added to the substrate potential Vw with respect to the integrated film thickness, which is measured in step S2 above, the reference attraction voltage with respect to the integrated film thickness Vr = Vw + Vc₀ is obtained (see a dotted line in the graph in Fig. 3). The potential difference Vc₀ may be obtained based on a required attraction force F. Since there is a relationship [(integrated film thickness) = (film thickness per substrate in film forming) × (the number of processed substrates)], the set attraction voltage V to be set for each number of processed substrates can be calculated based on the reference attraction voltage Vr.

The set attraction voltage V to be set for each number of processed substrates is set as follows. For example, as shown in Fig. 3, when the number of processed substrates is 1, a voltage V₁ at the start of processing of a first substrate is set as the set attraction voltage V. When the number of processed substrates is 2, a voltage V₂ at the start of processing of a second substrate is set as the set attraction voltage V. When the number of processed substrates is 3, a voltage V₃ at the start of processing of a third substrate is set as the set attraction voltage V. That is, the set voltage is changed for each number of processed substrates. In this embodiment, the set voltage V₁, V₂, V₃ ... is set as described above based on the measured substrate potential Vw. This enables accurate control based on the measurement.

In the actual manufacturing process, the set attraction voltage V of the electrostatic chuck power supply 13 is changed in accordance with the number of processed substrates on the basis of the set attraction voltage V for the number of processed substrates, which is calculated in Step S4 above (Step S5). By changing the set attraction voltage V in accordance with the number of processed substrates as described above, the potential difference Vc between the set attraction voltage V and the substrate potential Vw is made constant and thus the attraction force F is made constant. As a result, the substrate temperature can be made constant.

When the number of processed substrates reaches the number of substrates to be processed within the cleaning cycle set in Step S3, plasma cleaning is automatically started, and the inner wall of the vacuum chamber 2 is reset to an initial state (Step S6). Subsequently, Steps S5 and S6 above are repeated until processing of all the substrates is completed.

Meanwhile, the relationship between the integrated film thickness and the substrate potential Vw is not necessarily a linear relationship as shown in Fig. 3. However, when the film thickness per film forming is thin, when the cleaning cycle is short (the integrated film thickness before the cleaning is thin), or the like, the relationship between the integrated film thickness and the substrate potential Vw can be regarded as a linear relationship. In this case, films are deposited successively until the film thickness reaches the integrated film thickness at which the cleaning is to be performed, the relationship between the integrated film thickness and the substrate potential Vw is obtained in Step 2 above, and then the processes in Steps S3 to S6 described above may be performed. In this case, only one measurement is required in Step S2, and the relationship between the integrated film thickness and substrate potential Vw can be readily obtained.

Here, a method for measuring the substrate potential in Step S2 above is described.
The method for measuring the substrate potential is performed by using a publicly known method. For example, a method may be used in which a probe for measuring plasma is inserted into the plasma to measure a plasma potential and thereby the substrate potential is obtained. However, when the probe is inserted into the plasma, metal contamination from the probe or an impact of change in plasma density profile on the measurement is conceivable. Thus, it is desirable to obtain the substrate potential by using a method like one described in Patent Document 1.

The method for measuring the substrate potential in Patent Document 1 is a method for obtaining the substrate potential based on the relationship between the substrate temperature and an output voltage to an electrostatic chuck under a certain plasma processing condition. Processes applied to this embodiment are described specifically by referring to Fig. 1.

In this embodiment, as described in Step S2 above, the conditioning of the vacuum chamber 2 is performed and thereafter film forming is performed on the substrate 6 at constant film thickness intervals based on the certain film forming conditions. Then, under the plasma processing condition equivalent to the film forming condition set in Step S1 above, the temperature of the substrate 6 is measured by the temperature detector 27 while changing an output voltage of the electrostatic chuck power supply 13, every time film forming up to the constant film thickness is performed. At this time, the temperature of the substrate placement portion 7 is controlled to within an appropriate range by the temperature controller 14. In addition, when the output voltage of the electrostatic chuck power supply 13 is applied to the substrate placement portion 7, the substrate 6 is sucked onto the substrate placement portion 7 by an electrostatic suction force. In this measurement, when the attraction force F acting on the substrate 6 becomes zero, that is, when the output voltage of the electrostatic chuck power supply 13 and the potential of the substrate 6 have equal potentials, the temperature of the substrate 6 reaches the maximum. From this, the output voltage of the electrostatic chuck power supply 13 at the maximum temperature of the substrate 6 is detected as the substrate potential Vw.

This is because, when the attraction force F between the substrate placement portion 7 and the substrate 6 is zero, direct thermal conduction between the substrate placement portion 7 and the substrate 6 disappears, and the plasma influences the temperature of the substrate 6 and thus the temperature reaches the maximum. In addition, when there exists an attraction force F between the substrate placement portion 7 and the substrate 6, the temperature of the substrate 6 becomes close to the temperature of substrate placement portion 7 due to direct thermal conduction between the substrate placement portion 7 and the substrate 6.

As described above, the electrostatic attraction voltage to be applied to the single electrode is controlled based on the number of processed substrates, by performing the method for controlling a substrate attraction force according to this embodiment. Thus, the substrate attraction force is controlled to be constant independent of the number of processed substrates. As a result, the substrate temperature at the time of processing can be kept constant, and thus the process stability can be obtained. Moreover, this leads to reduction in cleaning frequency and improvement of CoO.

Note that this embodiment is provided on the assumption that the bias power is constant (including zero) and the bias power may be zero. Thus, this embodiment is also applicable to a plasma CVD apparatus without bias application means (the capacitor 9, the matching circuit 10, the bias power supply 11, and the like).

### EMBODIMENT 2

In this embodiment, a method for controlling a substrate attraction force, which is different from that in Embodiment 1, is performed in the plasma CVD apparatus described in Embodiment 1 (see Fig. 1). Thereby, a substrate attraction force is controlled to be constant, and consequently the substrate temperature is kept constant. Thus, the process stability is obtained.

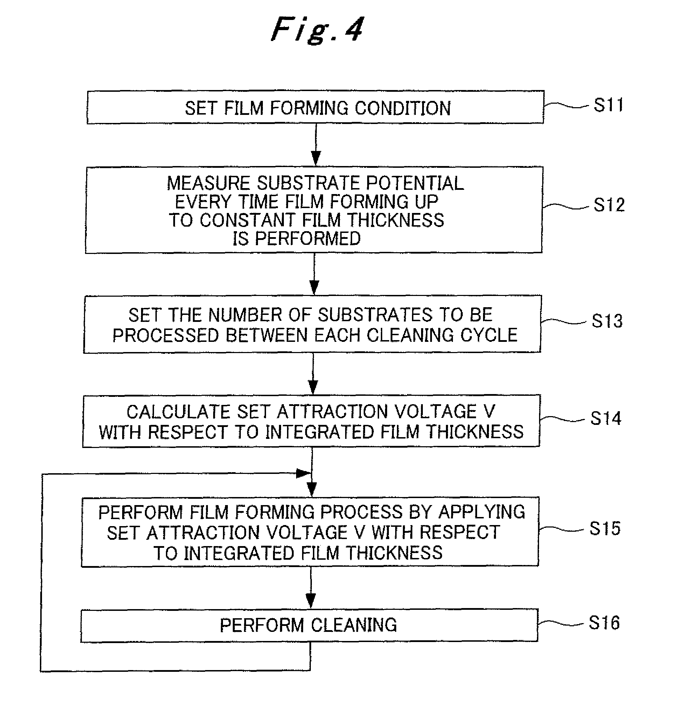

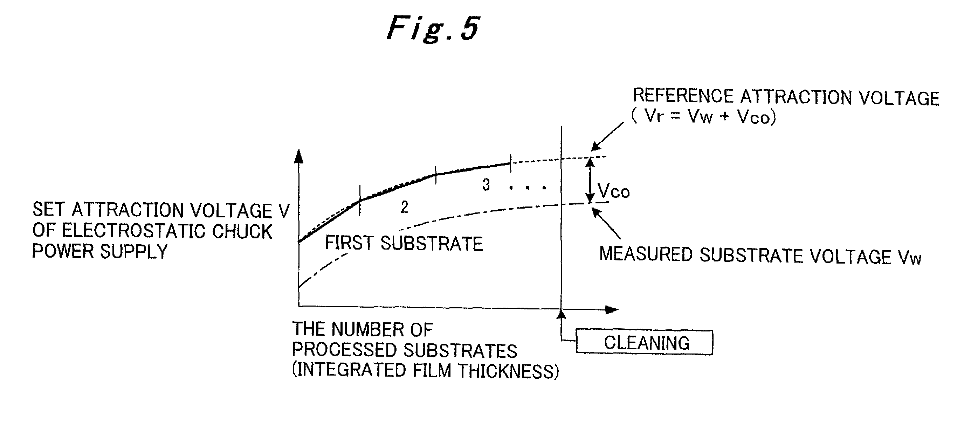

Hereinbelow, the method for controlling a substrate attraction force according to this embodiment is described by referring to Fig. 4 and Fig. 5. Note that Fig. 4 is a flowchart showing the method for controlling a substrate attraction force according to this embodiment and Fig. 5 is a time chart explaining the method for controlling a substrate attraction force according to this embodiment.

The method for controlling a substrate attraction force according to this embodiment is performed by the controller 26 shown in Fig. 1 in steps shown in Fig. 4.

In the method for controlling a substrate attraction force according to this embodiment, Steps S11 to S13 are the same as Steps S1 to S3 in the flowchart in Embodiment 1 (Fig. 2). Specifically, a film forming condition (note that bias power is zero or constant) to be used in an actual manufacturing process is set (Step S11). Then, after conditioning of the vacuum chamber 2, film forming is performed on the substrate 6 at constant film thickness intervals based on this film forming condition. Every time film forming up to the constant film thickness is performed, a substrate potential is measured by the method described above (Step S12). Then, change of a substrate potential Vw with respect to an integrated film thickness is obtained at every constant integrated film thickness intervals. Thereby, a relationship between the integrated film thickness and the substrate potential Vw (see a chain line in a graph in Fig. 5) is obtained. Thereafter, the number of substrates to be processed between each cleaning cycle is set (Step S13).

In this embodiment, Steps S14 and S15 are different from Steps S4 and S5 in the flowchart in Embodiment 1 (Fig. 2).

Specifically, a set attraction voltage V to be set with respect to the integrated film thickness is calculated (Step S14, see a solid line in the graph in Fig. 5).
More specifically, a reference attraction voltage with respect to the integrated film thickness Vr = Vw + Vc₀ (see a dotted line in the graph in Fig. 5) is obtained based on the relationship of the substrate potential Vw with the integrated film thickness, which is obtained in Step S12 above. The reference attraction voltage Vr serves as a reference when the set attraction voltage V is set for the electrostatic chuck power supply 13. Then, the set attraction voltage V to be set with respect to the integrated film thickness is calculated based on the reference attraction voltage Vr.

The set attraction voltage V to be set with respect to the integrated film thickness is set as follows. For example, based on the reference attraction voltage Vr shown by the dotted line as shown in Fig. 5, change of the set attraction voltage V corresponding to a certain number of processed substrates (for example, one) is approximated to have a linear relationship (see the solid line in the graph in Fig. 5). Then, the set attraction voltage V with respect to the integrated film thickness corresponding to the number of processed substrates is set along the linear line. In other words, in Embodiment 1, the set attraction voltage V of the electrostatic chuck power supply 13 is kept constant while one substrate 6 is processed. In this embodiment, the set attraction voltage V of the electrostatic chuck power supply 13 is changed in accordance with the integrated film thickness even while one substrate 6 is processed.

Here, the set attraction voltage V with respect to the integrated film thickness is set by also using a collinear approximation. However, note that if the collinear approximation is not accurate enough, a polynomial approximation or the like may be used to more accurately set the set attraction voltage V with respect to the integrated film thickness.

In the actual manufacturing process, the set attraction voltage V of the electrostatic chuck power supply 13 is changed in accordance with the integrated film thickness on the basis of the set attraction voltage V with respect to the integrated film thickness, which is calculated in Step S14 above (Step S15). By changing the set attraction voltage V in accordance with the integrated film thickness as described above, a potential difference Vc between the set attraction voltage V and the substrate potential Vw is made constant and thus an attraction force F is made constant. As a result, the substrate temperature can be made constant.

When the number of processed substrates reaches the number of substrates to be processed within the cleaning cycle set in Step S13, cleaning is automatically started, and the inner wall of the vacuum chamber 2 is reset to an initial state (Step S16). Subsequently, Steps S15 and S16 above are repeated until processing of all the substrates is completed.

As described above, the electrostatic attraction voltage to be applied to the single electrode is controlled based on the integrated film thickness, by performing the method for controlling a substrate attraction force according to this embodiment. Thus, the substrate attraction force is controlled to be constant independent of the integrated film thickness. As a result, the substrate temperature at the time of processing can be kept constant, and thus the process stability can be obtained. Moreover, this leads to reduction in cleaning frequency and improvement of CoO.

Besides, this embodiment is effective when the relationship between the integrated film thickness and the substrate potential changes largely, or when the thickness per film forming is thick. When the relationship between the integrated film thickness and the substrate potential changes largely, or when the thickness per film forming is thick, the substrate potential Vw largely fluctuates before and after the film forming, and thus the film quality of a formed thin film is changed in a depositing direction (thickness direction). Nevertheless, the set attraction voltage V of the electrostatic chuck power supply 13 is changed, as in this embodiment, in accordance with the integrated film thickness during film forming, and thus the change of the film quality in the depositing direction (thickness direction) can be reduced.

Note that this embodiment is provided also on the assumption that bias power is constant (including zero), and is also applicable to a plasma CVD apparatus without bias application means.

### EMBODIMENT 3

In this embodiment, a method for controlling a substrate attraction force, which is different from those in Embodiments 1 and 2, is performed also in the plasma CVD apparatus described in Embodiment 1 (see Fig. 1). Thereby, a substrate attraction force is controlled to be constant, and consequently the substrate temperature is kept constant. Thus, the process stability is obtained.

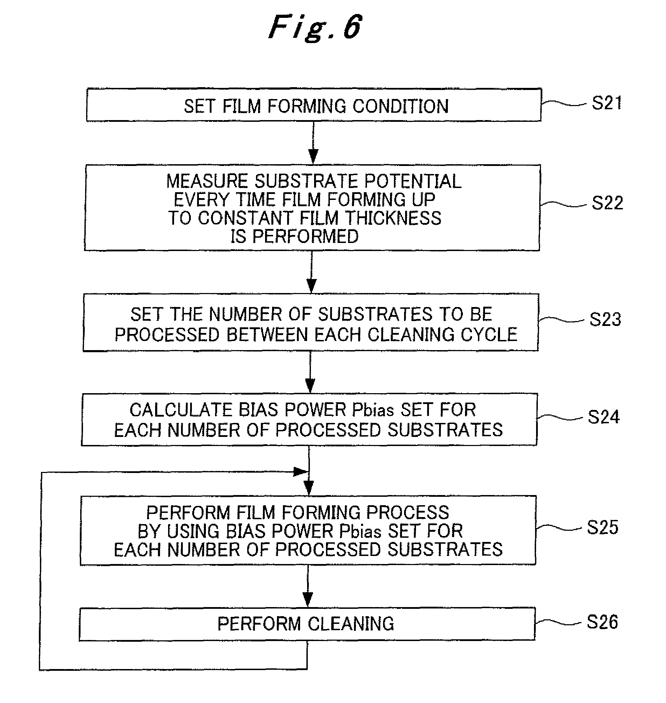

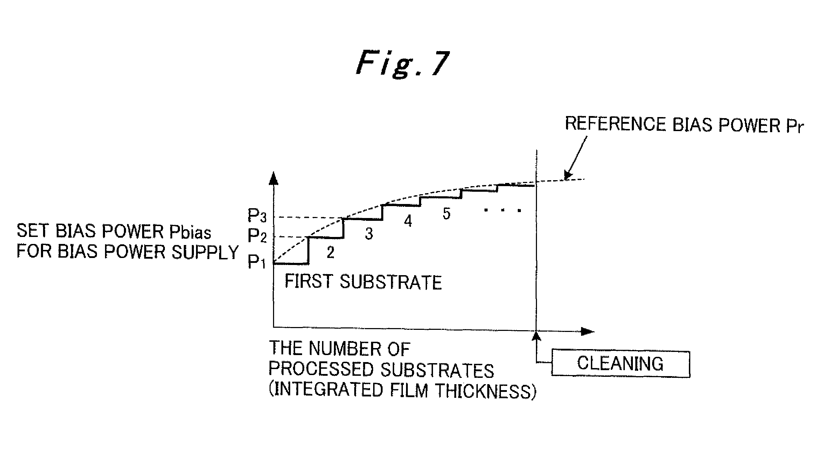

Hereinbelow, the method for controlling a substrate attraction force according to this embodiment is described by referring to Fig. 6 and Fig. 7. Note that Fig. 6 is a flowchart showing the method for controlling a substrate attraction force according to this embodiment and Fig. 7 is a time chart explaining the method for controlling a substrate attraction force according to this embodiment.

The method for controlling a substrate attraction force according to this embodiment is performed by the controller 26 shown in Fig. 1 in steps shown in Fig. 6.

In the method for controlling a substrate attraction force according to this embodiment as well, Steps S21 to S23 are the same as Steps S1 to S3 in the flowchart in Embodiment 1 (Fig. 2). Specifically, a film forming condition to be used in an actual manufacturing process is set (Step S21). Then, after conditioning of the vacuum chamber 2, film forming is performed on the substrate 6 at constant film thickness intervals based on this film forming condition. Every time film forming up to the constant film thickness is performed, a substrate potential is measured by the method described above (Step S22). Then, change of a substrate potential Vw with respect to an integrated film thickness is obtained at every constant integrated film thickness intervals. Thereby, a relationship between the integrated film thickness and the substrate potential Vw (see the chain line in a graph in Fig. 3) is obtained. Thereafter, the number of substrates to be processed between each cleaning cycle is set (Step S23). Note that bias power is zero or constant in Step S22 as in Embodiment 1.

In this embodiment, Steps S24 and S25 are different from Steps S4 and S5 in the flowchart in Embodiment 1 (Fig. 2) and Steps S14 and S15 in the flowchart in Embodiment 2 (Fig. 4).

Specifically, a set bias power Pbias to be set for each number of processed substrates is calculated (Step S24, see a solid line in a graph in Fig. 7).
More specifically, a reference bias power Pr with respect to the integrated film thickness (see a dotted line in the graph in Fig. 7) is first obtained based on the relationship of the substrate potential Vw with the integrated film thickness, which is obtained in Step S22 above. Although the detail will be described later, the reference bias power Pr is obtained from a self-bias potential Vs which makes constant a potential difference Vc between a set attraction voltage V (constant in this embodiment) to be set for the electrostatic chuck power supply 13 and the substrate potential Vw, that is, from the self-bias potential Vs which offsets an increment of the substrate potential Vw, which is involved with the integrated film thickness. The reference bias power Pr serves as a reference when the set bias power Pbias is set for the bias power supply 11. Subsequently, the set bias power Pbias to be set for each number of processed substrates is calculated based on the reference bias power Pr thus obtained.

### The reference bias power Pr will be described in more detail.

As shown in Fig. 3, the substrate potential Vw is increased in accordance with the integrated film thickness. The reason for this is the fluctuation of a plasma potential Vp as described by using Part (a) of Fig. 12 above. If the self-bias potential Vs is appropriately controlled, that is, if the bias power Pbias is appropriately controlled, the increment of the substrate potential Vw involved with the integrated film thickness can be offset. Consequently, the voltage difference Vc between the set attraction voltage V set for the electrostatic chuck power supply 13 and the substrate potential Vw can be made constant. The self-bias potential Vs is increased in accordance with the set bias power Pbias as shown in Part (b) of Fig. 11 above, but acts on the plasma potential Vp in a negative direction. This means that the bias power Pbias may be increased so that the increment of the substrate potential Vw involved with the integrated film thickness can be offset. Accordingly, the set bias power Pbias with respect to the integrated film thickness, that is, the reference bias power Pr can be obtained based on these relationships.

The set bias power Pbias to be set for each number of processed substrates is set as follows. For example, as shown in Fig. 7, when the number of processed substrates is 1, power P₁ at the start of processing of a first substrate is set as the set bias power Pbias. When the number of processed substrates is 2, power P₂ at the start of processing of a second substrate is set as the set bias power Pbias. When the number of processed substrates is 3, power P₃ at the start of processing of a third substrate is set as the set bias power Pbias. That is, the set bias power Pbias is changed for each number of processed substrates. In this embodiment, the set bias power Pbias = P₁, P₂, P₃ ... is set as described above based on the measured substrate potential Vw. This enables accurate control based on the measurement.

In the actual manufacturing process, the set bias power Pbias of the bias power supply 11 is changed in accordance with the number of processed substrates on the basis of the set bias power Pbias for the number of processed substrates, which is calculated in Step S24 above (Step S25). At this time, the set attraction voltage V to be set for the electrostatic chuck power supply 13 is constant. By changing the set bias power Pbias in accordance with the number of processed substrates as described above, the potential difference Vc between the set attraction voltage V of the electrostatic chuck power supply 13 and the substrate potential Vw is made constant and thus an attraction force F is made constant. As a result, the substrate temperature can be made constant.

When the number of processed substrates reaches the number of substrates to be processed within the cleaning cycle set in Step S23, cleaning is automatically started, and the inner wall of the vacuum chamber 2 is reset to an initial state (Step S26). Subsequently, Steps S25 and S26 above are repeated until processing of all the substrates is completed.

As described above, the self bias potential is controlled based on the number of processed substrates, by performing the method for controlling a substrate attraction force according to this embodiment. Thus, the substrate attraction force is controlled to be constant independent of the number of processed substrates. As a result, the substrate temperature at the time of processing can be kept constant, and thus the process stability can be obtained. Moreover, this leads to reduction in cleaning frequency and improvement of CoO. Note that since bias power relates to coverage and an embedding performance when film forming is performed, this embodiment is not effective for such a usage, but is effective for processing after embedding by bias application and mere heating processing.

### EMBODIMENT 4

In this embodiment, a method for controlling a substrate attraction force, which is different from those in Embodiments 1 to 3, is performed also in the plasma CVD apparatus described in Embodiment 1 (see Fig. 1). Thereby, a substrate attraction force is controlled to be constant, and consequently the substrate temperature is kept constant. Thus, the process stability is obtained.

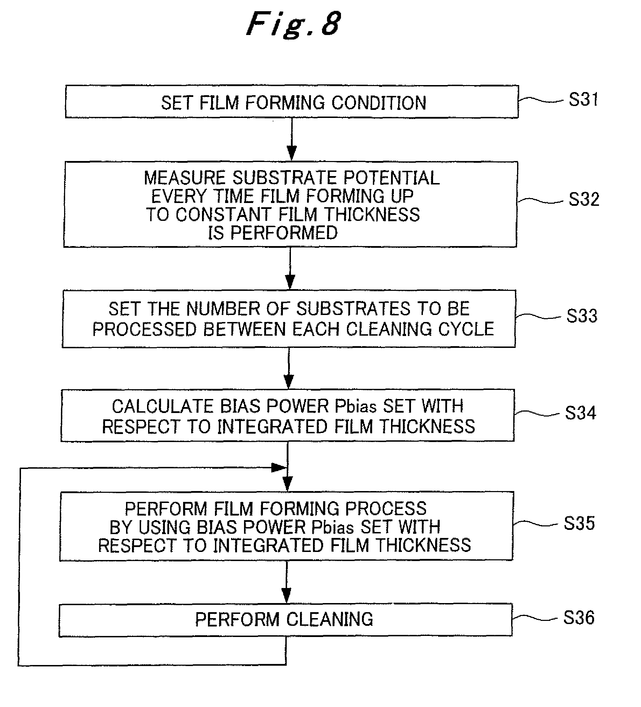

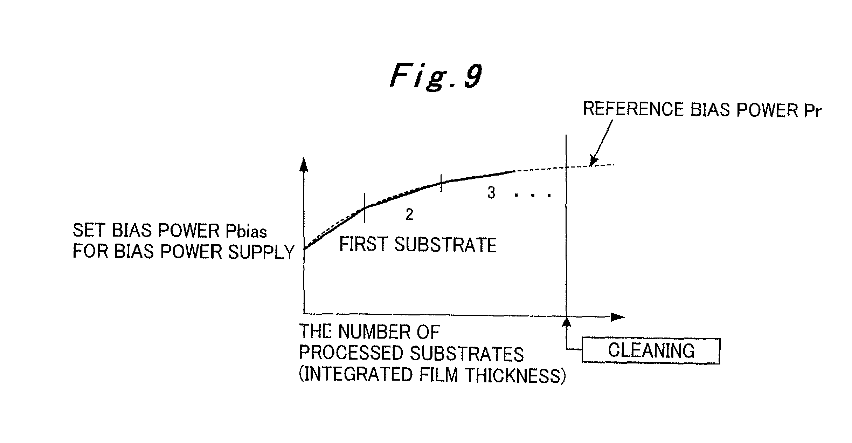

Hereinbelow, the method for controlling a substrate attraction force according to this embodiment is described by referring to Fig. 8 and Fig. 9. Note that Fig. 8 is a flowchart showing the method for controlling a substrate attraction force according to this embodiment and Fig. 9 is a time chart explaining the method for controlling a substrate attraction force according to this embodiment.

The method for controlling a substrate attraction force according to this embodiment is performed by the controller 26 shown in Fig. 1 in steps shown in Fig. 8.

In the method for controlling a substrate attraction force according to this embodiment as well, Steps S31 to S33 are the same as Steps S1 to S3 in the flowchart in Embodiment 1 (Fig. 2). Specifically, a film forming condition to be used in an actual manufacturing process is set (Step S31). Then, after conditioning of the vacuum chamber 2, film forming is performed on the substrate 6 at constant film thickness intervals based on this film forming condition. Every time film forming up to the constant film thickness is performed, a substrate potential is measured by the method described above (Step S32). Then, change of a substrate potential Vw with respect to an integrated film thickness is obtained at every constant integrated film thickness intervals. Thereby, a relationship between the integrated film thickness and the substrate potential Vw (see the chain line in a graph in Fig. 3) is obtained. Thereafter, the number of substrates to be processed between each cleaning cycle is set (Step S33). Note that bias power is zero or constant in Step S32 as in Embodiment 1.

In this embodiment, Steps S34 and S35 are different from Steps S4 and S5 in the flowchart in Embodiment 1 (Fig- 2), Steps S14 and S15 in the flowchart in Embodiment 2 (Fig. 4), and Steps S24 and S25 in the flowchart in Embodiment 2 (Fig. 6).

Specifically, a set bias power Pbias to be set for the integrated film thickness is calculated (Step S34, see a solid line in a graph in Fig. 9).
More specifically, a reference bias power Pr with respect to the integrated film thickness (see a dotted line in the graph in Fig. 9) is first obtained based on the relationship of the substrate potential Vw with the integrated film thickness, which is obtained in Step S32 above. As described in Embodiment 3, the reference bias power Pr is obtained from a self-bias potential Vs which makes constant a potential difference Vc between a set attraction voltage V (constant in this embodiment) to be set for the electrostatic chuck power supply 13 and the substrate potential Vw, that is, from the self-bias potential Vs which offsets an increment of the substrate potential Vw, which is involved with the integrated film thickness. The reference bias power Pr serves as a reference when the set bias power Pbias is set for the bias power supply 11. Subsequently, the set bias power Pbias to be set with respect to the integrated film thickness is calculated based on the reference bias power Pr thus obtained.

The set bias power Pbias to be set with respect to the integrated film thickness is set as follows. For example, based on the reference bias power Pr shown by the dotted line as shown in Fig. 9, change of a bias power P corresponding to a certain number of processed substrates (for example, one) is approximated to have a linear relationship (see the solid line in the graph in Fig. 9). Then, the set bias power Pbias with respect to the integrated film thickness corresponding to the number of processed substrates is set along the linear line. In other words, in Embodiment 3, the set bias power Pbias of the bias power supply 11 is kept constant while one substrate 6 is processed. In this embodiment, the set bias power Pbias of the bias power supply 11 is changed in accordance with the integrated film thickness even while one substrate 6 is processed.

Here, the set bias power Pbias with respect to the integrated film thickness is set also by using the collinear approximation. However, note that if the collinear approximation is not accurate enough, a polynomial approximation or the like may be used to more accurately set the bias power P with respect to the integrated film thickness.

In the actual manufacturing process, the bias power P of the bias power supply 11 is changed in accordance with the integrated film thickness on the basis of the set bias power Pbias with respect to the integrated film thickness, which is calculated in Step S34 above (Step S35). At this time, the set attraction voltage V to be set for the electrostatic chuck power supply 13 is constant. By changing the set bias power Pbias in accordance with the integrated film thickness as described above, the potential difference Vc between the set attraction voltage V set for the electrostatic chuck power supply 13 and the substrate potential Vw is made constant and thus an attraction force F is made constant. As a result, the substrate temperature can be made constant.

When the number of processed substrates reaches the number of substrates to be processed within the cleaning cycle set in Step S23, cleaning is automatically started, and the inner wall of the vacuum chamber 2 is reset to an initial state (Step S36). Subsequently, Steps S35 and S36 above are repeated until processing of all the substrates is completed.

As described above, the self bias potential is controlled based on the integrated film thickness, by performing the method for controlling a substrate attraction force according to this embodiment. Thus, the substrate attraction force is controlled to be constant independent of the integrated film thickness. As a result, the substrate temperature at the time of processing can be kept constant, and thus the process stability can be obtained. Moreover, this leads to reduction in cleaning frequency and improvement of CoO.

Besides, this embodiment is effective, as in Embodiment 2 above, when the relationship between the integrated film thickness and the substrate potential changes largely, or when the thickness per film forming is thick. Since the set bias power Pbias to be set for the bias power supply 11 is changed in accordance with the integrated film thickness during film forming, change of the film quality in the depositing direction (thickness direction) can be reduced. Note that since bias power relates to coverage and an embedding performance when film forming is performed, this embodiment is not effective for such a usage, but is effective for processing after embedding by bias application and mere heating processing.

Meanwhile, the descriptions have been given in Embodiments 1 to 4 above by showing a plasma CVD apparatus as an example. With a principal of the present invention taken into consideration, Embodiments 1 to 4 are also applicable to a plasma etching apparatus. Specifically, a byproduct by etching deposits on an inner wall of a chamber in accordance with the number of processed substrates also in the plasma etching apparatus, and the plasma potential is influenced in accordance with the deposit film thickness of the byproduct. In this case, a set attraction voltage to be set for an electrostatic chuck power supply and set bias power to be set for a bias power supply are calculated in association with an integrated etching amount (integrated processing time) therewith, and then etching processing is performed by using the calculated conditions. Thereby, a stable process result can be obtained.

### INDUSTRIAL APPLICABILITY

The present invention is favorable for a plasma processing apparatus including a substrate attracting device having a single electrode.

## Claims

1. A plasma processing apparatus comprising:
electrostatic attraction means for electrostatically attracting a substrate accommodated in a vacuum chamber onto a support table by applying an attraction voltage to a single electrode;
inductively-coupled plasma generation means for changing a gas in the vacuum chamber into plasma; and
control means for controlling the electrostatic attraction means and the plasma generation means,
the plasma processing apparatus performing plasma processing on the substrate attracted onto the support table, wherein
at the time of the plasma processing of the substrate, the control means increases the attraction voltage applied to the single electrode in accordance with the number of successively processed substrates or an integrated processing time.

2. A plasma processing apparatus comprising:
electrostatic attraction means for electrostatically attracting a substrate accommodated in a vacuum chamber onto a support table by applying an attraction voltage to a single electrode;
inductively-coupled plasma generation means for changing a gas in the vacuum chamber into plasma; and
control means for controlling the electrostatic attraction means and the plasma generation means,
the plasma processing apparatus performing plasma processing on the substrate attracted onto the support table, wherein
in advance, the control means measures change of a substrate potential every constant integrated processing time interval under a predetermined plasma processing condition, obtains each reference attraction voltage at every constant integrated processing time interval by adding a potential corresponding to a desired electrostatic attraction force to each of the measured substrate potentials, and calculates each set attraction voltage to be applied to the single electrode for each number of processed substrates on the basis of each of the obtained reference attraction voltages, and
at the time of the plasma processing of the substrate under the predetermined plasma processing condition, the control means applies each
of the calculated set attraction voltages to the single electrode for each number of processed substrates, so that the electrostatic attraction force on the substrate is made constant.

3. A plasma processing apparatus comprising:
electrostatic attraction means for electrostatically attracting a substrate accommodated in a vacuum chamber onto a support table by applying an attraction voltage to a single electrode;
inductively-coupled plasma generation means for changing a gas in the vacuum chamber into plasma; and
control means for controlling the electrostatic attraction means and the plasma generation means,
the plasma processing apparatus performing plasma processing on the substrate attracted onto the support table, wherein
in advance, the control means measures change of a substrate potential every constant integrated processing time interval under a predetermined plasma processing condition, obtains each reference attraction voltage at every constant integrated processing time interval by adding a potential corresponding to a desired electrostatic attraction force to each of the measured substrate potentials, and calculates each set attraction voltage to be applied to the single electrode on the basis of each of the obtained reference attraction voltages in association with the integrated processing time, and
at the time of the plasma processing of the substrate under the predetermined plasma processing condition, the control means applies each of the calculated set attraction voltages to the single electrode in accordance with the integrated processing time, so that the electrostatic attraction force on the substrate is made constant.

4. A plasma processing apparatus comprising:
electrostatic attraction means for electrostatically attracting a substrate accommodated in a vacuum chamber onto a support table by applying an attraction voltage to a single electrode;
bias application means for applying a self-bias potential to the substrate by supplying bias power to the single electrode while sharing the single electrode;
inductively-coupled plasma generation means for changing a gas in the vacuum chamber into plasma; and
control means for controlling the electrostatic attraction means, the bias application means and the plasma generation means,
the plasma processing apparatus performing plasma processing on the substrate attracted onto the support table, wherein
at the time of the plasma processing of the substrate, the control means keeps the bias power constant and increases the attraction voltage applied to the single electrode in accordance with the number of successively processed substrates or an integrated processing time.

5. A plasma processing apparatus comprising:
electrostatic attraction means for electrostatically attracting a substrate accommodated in a vacuum chamber onto a support table by applying an attraction voltage to a single electrode;
bias application means for applying a self-bias potential to the substrate by supplying bias power to the single electrode while sharing the single electrode;
inductively-coupled plasma generation means for changing a gas in the vacuum chamber into plasma; and
control means for controlling the electrostatic attraction means, the bias application means and the plasma generation means,
the plasma processing apparatus performing plasma processing on the substrate attracted onto the support table, wherein
in advance, the control means measures change of a substrate potential every constant integrated processing time interval under a predetermined plasma processing condition while the bias power is constant, obtains each reference attraction voltage at every constant integrated processing time interval by adding a potential corresponding to a desired electrostatic attraction force to each of the measured substrate potentials, and calculates each set attraction voltage to be applied to the single electrode for each number of processed substrates on the basis of each of the obtained reference attraction voltages, and
at the time of the plasma processing of the substrate under the predetermined plasma processing condition, the control means applies each of the calculated set attraction voltages to the single electrode for each
number of processed substrates, so that the electrostatic attraction force on the substrate is made constant.

6. A plasma processing apparatus comprising:
electrostatic attraction means for electrostatically attracting a substrate accommodated in a vacuum chamber onto a support table by applying an attraction voltage to a single electrode;
bias application means for applying a self-bias potential to the substrate by supplying bias power to the single electrode while sharing the single electrode;
inductively-coupled plasma generation means for changing a gas in the vacuum chamber into plasma; and
control means for controlling the electrostatic attraction means, the bias application means and the plasma generation means,
the plasma processing apparatus performing plasma processing on the substrate attracted onto the support table, wherein
in advance, the control means measures change of a substrate potential every constant integrated processing time interval under a predetermined plasma processing condition while the bias power is constant, obtains each reference attraction voltage at every constant integrated processing time interval by adding a potential corresponding to a desired electrostatic attraction force to each of the measured substrate potentials, and calculates each set attraction voltage to be applied to the single electrode on the basis of each of the obtained reference attraction voltages in association with the integrated processing time, and
at the time of the plasma processing of the substrate under the predetermined plasma processing condition, the control means applies each of the calculated set attraction voltages to the single electrode in accordance with the integrated processing time, so that the electrostatic attraction force on the substrate is made constant.

7. A plasma processing apparatus comprising:
electrostatic attraction means for electrostatically attracting a substrate accommodated in a vacuum chamber onto a support table by applying an attraction voltage to a single electrode;
bias application means for applying a self-bias potential to the substrate by supplying bias power to the single electrode while sharing the single electrode;
inductively-coupled plasma generation means for changing a gas in the vacuum chamber into plasma; and
control means for controlling the electrostatic attraction means, the bias application means and the plasma generation means,
the plasma processing apparatus performing plasma processing on the substrate attracted onto the support table, wherein
at the time of the plasma processing of the substrate, the control means keeps the attraction voltage constant and increases the bias power to be supplied to the single electrode in accordance with the number of successively processed substrates or an integrated processing time.

8. A plasma processing apparatus comprising:
electrostatic attraction means for electrostatically attracting a substrate accommodated in a vacuum chamber onto a support table by applying an attraction voltage to a single electrode;
bias application means for applying a self-bias potential to the substrate by supplying bias power to the single electrode while sharing the single electrode;
inductively-coupled plasma generation means for changing a gas in the vacuum chamber into plasma; and
control means for controlling the electrostatic attraction means, the bias application means and the plasma generation means,
the plasma processing apparatus performing plasma processing on the substrate attracted onto the support table, wherein
in advance, the control means measures change of a substrate potential every constant integrated processing time interval under a predetermined plasma processing condition while the bias power is set at zero, obtains each reference bias power at every constant integrated processing time interval by obtaining each bias power corresponding to the self-bias potential offsetting each change of the measured substrate potentials, and calculates each set bias power to be supplied to the single electrode for each number of processed substrates on the basis of each of the obtained reference bias powers, and
at the time of the plasma processing of the substrate under the predetermined plasma processing condition, the control means keeps the attraction voltage constant and supplies each of the calculated set bias powers to the single electrode for each number of processed substrates, so that an electrostatic attraction force on the substrate is made constant.

9. A plasma processing apparatus comprising:
electrostatic attraction means for electrostatically attracting a substrate accommodated in a vacuum chamber onto a support table by applying an attraction voltage to a single electrode;
bias application means for applying a self-bias potential to the substrate by supplying bias power to the single electrode while sharing the single electrode;
inductively-coupled plasma generation means for changing a gas in the vacuum chamber into plasma; and
control means for controlling the electrostatic attraction means, the bias application means and the plasma generation means,
the plasma processing apparatus performing plasma processing on the substrate attracted onto the support table, wherein
in advance, the control means measures change of a substrate potential every constant integrated processing time interval under a predetermined plasma processing condition while the bias power is set at zero, obtains each reference bias power at every constant integrated processing time interval by obtaining each bias power corresponding to the self-bias potential offsetting each change of the measured substrate potentials, and calculates each set bias power to be supplied to the single electrode on the basis of each of the obtained reference bias powers in association with the integrated processing time, and
at the time of the plasma processing of the substrate under the predetermined plasma processing condition, the control means keeps the attraction voltage constant and supplies each of the calculated set bias powers to the single electrode in accordance with the integrated processing time, so that an electrostatic attraction force on the substrate is made constant.

10. A method for controlling a substrate attraction force in a plasma processing apparatus which electrostatically attracts a substrate accommodated in a vacuum chamber onto a support table by applying an attraction voltage to a single electrode of electrostatic attraction means, changes a gas in the vacuum chamber into plasma by inductively-coupled plasma generation means, and performs plasma processing on the substrate attracted onto the support table,
the method comprising, at the time of the plasma processing of the substrate, increasing the attraction voltage applied to the single electrode in accordance with the number of successively processed substrates or an integrated processing time.

11. A method for controlling a substrate attraction force in a plasma processing apparatus which electrostatically attracts a substrate accommodated in a vacuum chamber onto a support table by applying an attraction voltage to a single electrode of electrostatic attraction means, changes a gas in the vacuum chamber into plasma by inductively-coupled plasma generation means, and performs plasma processing on the substrate attracted onto the support table,
the method comprising:
in advance, measuring change of a substrate potential every constant integrated processing time interval under a predetermined plasma processing condition, obtaining each reference attraction voltage at every constant integrated processing time interval by adding a potential corresponding to a desired electrostatic attraction force to each of the measured substrate potentials, and calculating each set attraction voltage to be applied to the single electrode for each number of processed substrates on the basis of each of the obtained reference attraction voltages; and
at the time of the plasma processing of the substrate under the predetermined plasma processing condition, applying each of the calculated set attraction voltages to the single electrode for each number of processed substrates, so that the electrostatic attraction force on the substrate is made constant.

12. A method for controlling a substrate attraction force in a plasma processing apparatus which electrostatically attracts a substrate accommodated in a vacuum chamber onto a support table by applying an attraction voltage to a single electrode of electrostatic attraction means, changes a gas in the vacuum chamber into plasma by inductively-coupled plasma
generation means, and performs plasma processing on the substrate attracted onto the support table,
the method comprising:
in advance, measuring change of a substrate potential every constant integrated processing time interval under a predetermined plasma processing condition, obtaining each reference attraction voltage at every constant integrated processing time interval by adding a potential corresponding to a desired electrostatic attraction force to each of the measured substrate potentials, and calculating each set attraction voltage to be applied to the single electrode on the basis of each of the obtained reference attraction voltages in association with the integrated processing time; and
at the time of the plasma processing of the substrate under the predetermined plasma processing condition, applying each of the calculated set attraction voltages to the single electrode in accordance with the integrated processing time, so that the electrostatic attraction force on the substrate is made constant.

13. A method for controlling a substrate attraction force in a plasma processing apparatus which electrostatically attracts a substrate accommodated in a vacuum chamber onto a support table by applying an attraction voltage to a single electrode of electrostatic attraction means, applies a self-bias potential to the substrate by supplying bias power to the single electrode by bias application means sharing the single electrode, changes a gas in the vacuum chamber into plasma by inductively-coupled plasma generation means, and performs plasma processing on the substrate attracted onto the support table,
the method comprising, at the time of the plasma processing of the substrate, keeping the bias power constant and increasing the attraction voltage applied to the single electrode in accordance with the number of successively processed substrates or an integrated processing time.

14. A method for controlling a substrate attraction force in a plasma processing apparatus which electrostatically attracts a substrate accommodated in a vacuum chamber onto a support table by applying an attraction voltage to a single electrode of electrostatic attraction means, applies a self-bias potential to the substrate by supplying bias power to
the single electrode by bias application means sharing the single electrode, changes a gas in the vacuum chamber into plasma by inductively-coupled plasma generation means, and performs plasma processing on the substrate attracted onto the support table,
the method comprising:
in advance, measuring change of a substrate potential every constant integrated processing time interval under a predetermined plasma processing condition while the bias power is constant, obtaining each reference attraction voltage at every constant integrated processing time interval by adding a potential corresponding to a desired electrostatic attraction force to each of the measured substrate potentials, and calculating each set attraction voltage to be applied to the single electrode for each number of processed substrates on the basis of each of the obtained reference attraction voltages; and
at the time of the plasma processing of the substrate under the predetermined plasma processing condition, applying each of the calculated set attraction voltages to the single electrode for each number of processed substrates, so that the electrostatic attraction force on the substrate is made constant.

15. A method for controlling a substrate attraction force in a plasma processing apparatus which electrostatically attracts a substrate accommodated in a vacuum chamber onto a support table by applying an attraction voltage to a single electrode of electrostatic attraction means, applies a self-bias potential to the substrate by supplying bias power to the single electrode by bias application means sharing the single electrode, changes a gas in the vacuum chamber into plasma by inductively-coupled plasma generation means, and performs plasma processing on the substrate attracted onto the support table,
the method comprising:
in advance, measuring change of a substrate potential every constant integrated processing time interval under a predetermined plasma processing condition while the bias power is constant, obtaining each reference attraction voltage at every constant integrated processing time interval by adding a potential corresponding to a desired electrostatic attraction force to each of the measured substrate potentials, and calculating each set attraction voltage to be applied to the single electrode on the basis of each of the obtained reference attraction voltages in association with the integrated processing time; and
at the time of the plasma processing of the substrate under the predetermined plasma processing condition, applying each of the calculated set attraction voltages to the single electrode in accordance with the integrated processing time, so that the electrostatic attraction force on the substrate is made constant.

16. A method for controlling a substrate attraction force in a plasma processing apparatus which electrostatically attracts a substrate accommodated in a vacuum chamber onto a support table by applying an attraction voltage to a single electrode of electrostatic attraction means, applies a self-bias potential to the substrate by supplying bias power to the single electrode by bias application means sharing the single electrode, changes a gas in the vacuum chamber into plasma by inductively-coupled plasma generation means, and performs plasma processing on the substrate attracted onto the support table,
the method comprising, at the time of the plasma processing of the substrate, keeping the attraction voltage constant and increasing the bias power to be supplied to the single electrode in accordance with the number of successively processed substrates or an integrated processing time.

17. A method for controlling a substrate attraction force in a plasma processing apparatus which electrostatically attracts a substrate accommodated in a vacuum chamber onto a support table by applying an attraction voltage to a single electrode of electrostatic attraction means, applies a self-bias potential to the substrate by supplying bias power to the single electrode by bias application means sharing the single electrode, changes a gas in the vacuum chamber into plasma by inductively-coupled plasma generation means, and performs plasma processing on the substrate attracted onto the support table,
the method comprising:
in advance, measuring change of a substrate potential every constant integrated processing time interval under a predetermined plasma processing condition while the bias power is set at zero, obtaining each reference bias power at every constant integrated processing time interval by obtaining each bias power corresponding to the self-bias potential offsetting each change of the measured substrate potentials, and calculating each set bias power to be supplied to the single electrode for each number of processed substrates on the basis of each of the obtained reference bias powers; and
at the time of the plasma processing of the substrate under the predetermined plasma processing condition, keeping the attraction voltage constant and supplying each of the calculated set bias powers to the single electrode for each number of processed substrates, so that an electrostatic attraction force on the substrate is made constant.

18. A method for controlling a substrate attraction force in a plasma processing apparatus which electrostatically attracts a substrate accommodated in a vacuum chamber onto a support table by applying an attraction voltage to a single electrode of electrostatic attraction means, applies a self-bias potential to the substrate by supplying bias power to the single electrode by bias application means sharing the single electrode, changes a gas in the vacuum chamber into plasma by inductively-coupled plasma generation means, and performs plasma processing on the substrate attracted onto the support table,
the method comprising:
in advance, measuring change of a substrate potential every constant integrated processing time interval under a predetermined plasma processing condition while the bias power is set at zero, obtaining each reference bias power at every constant integrated processing time interval by obtaining each bias power corresponding to the self-bias potential offsetting each change of the measured substrate potentials, and calculating each set bias power to be supplied to the single electrode on the basis of each of the obtained reference bias powers in association with the integrated processing time; and
at the time of the plasma processing of the substrate under the predetermined plasma processing condition, keeping the attraction voltage constant and supplying each of the calculated set bias powers to the single electrode in accordance with the integrated processing time, so that an electrostatic attraction force on the substrate is made constant.
